# EUROPEAN PATENT SPECIFICATION

(11) **EP 1 679 941 B1**
(45) Date of publication and mention of the grant of the patent: **09.11.2011**
(21) Application number: 04773626.9
(22) Date of filing: 29.09.2004
(51) Int. Cl.: H01L 51/50

(54) **ORGANIC ELECTROLUMINESCENT DEVICE**
ORGANISCHE ELEKTROLUMINESZENZVORRICHTUNG
DISPOSITIF ÉLECTROLUMINESCENT ORGANIQUE

(30) Priority: 03.10.2003 JP 2003345314
(43) Date of publication of application: 12.07.2006
(73) Proprietor: Pioneer Corporation, Kanagawa 212-0031 (JP)
(72) Inventor: TSUJI, Taishi, c/o Pioneer Corporation, Tsurugashima-shi Saitama 3502288 (JP); KAWAMI, Shin, c/o Pioneer Corporation, Tsurugashima-shi Saitama 3502288 (JP)
(74) Representative: Goddar, Heinz J.
(86) International application number: PCT/JP2004/014702
(87) International publication number: WO 2005/034588

(56) References cited:
- JP-A- 2000 243 574
- US-A1- 2001 019 783
- US-A1- 2002 027 416
- US-A1- 2003 054 197
- US-A1- 2003 180 574
- US-B1- 6 566 807

## Description

### TECHNICAL FIELD

The present invention relates to an organic electroluminescent device (hereinafter referred to as an organic EL device) which has one or more thin films (hereinafter referred to as an organic functional layer) including a light emitting layer. The light emitting layer is made of an organic compound showing electroluminescence in which light is emitted by the application of electric current.

### BACKGROUND ART

An organic EL device basically comprises an organic functional layer including a light emitting layer, and a positive electrode being a display electrode and a negative electrode between which the organic functional layer is sandwiched. When electrons and holes (positive holes) injected from both of the electrodes are recombined, excitons are generated. When the excitons return from an excited state to a ground state, light is emitted. The organic EL device comprises, for example, a transparent positive electrode, an organic functional layer, and a metal negative electrode which are successively laminated on a transparent substrate. The organic functional layer includes a plurality of layers with different functions such as, for example, a hole injection layer, a hole transport layer, a light emitting layer, an electron transport layer, and an electron injection layer which are laminated in this order from the side of the transparent electrode. The hole injection layer and the hole transport layer are made of materials having the function of transporting the holes, and the electron transport layer and the electron injection layer are made of materials having the function of transporting the electrons. These layers exclusive of the light emitting layer are referred to as an electric charge transport layer. The electric charge transport layer increases efficiency in the injection of electric charge into the light emitting layer, and hence significantly improves luminous efficiency as compared with a device comprising only the light emitting layer. Actually, some organic EL devices do not have such an electric charge transport layer, and some organic EL devices have the plurality of such electric charge transport layers. Furthermore, the light emitting layer may comprise a plurality of layers, as with, for example, a white light emitting device having two light emitting layers, that is, a blue light emitting layer and a red light emitting layer.

### DISCLOSURE OF THE INVENTION

If an organic functional layer of an organic EL device is made of a material with a low glass transition temperature, degradation in luminance, then degradation in chromaticity, and the like may occur when the device is put in an environment at a high temperature. Although the adjacent two layers can be made of materials with high glass transition temperatures, it is difficult to select materials (two materials) which have fine durability against continuous drive or fine device efficiency in luminous, out of such materials.

However, EL devices that do not show a degradation in luminance or a degradation in chromaticity are known from US 2003/180574 Al and US 2003/054197 A1.

An object of the present invention is to provide another organic EL device with high reliability.

An organic EL device according to the present invention involves all features mentioned in claim 1. Particularly, the invention is disclosed in the description of Example 6.

### BRIEF DESCRIPTION OF THE DRAWING

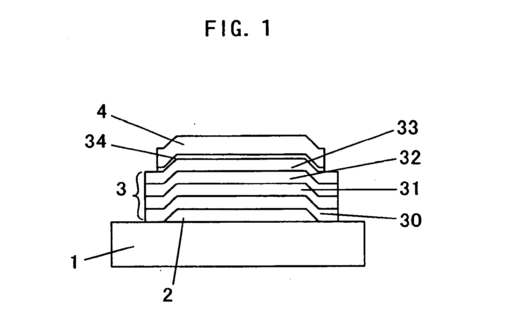

Fig. 1 is a diagram showing the configuration of an organic EL device according to an embodiment of the present invention.

### DETAILED DESCRIPTION OF THE INVENTION

If two layers adjacent to each other both made of materials having glass transition temperatures (Tg) in an organic functional layer of an organic EL device, then degradation in luminance, degradation in chromaticity and the like may occur when the device is put in an environment at a high temperature. In view of this circumstance, various prototypes of organic EL devices were fabricated and evaluated. Each organic EL device had an organic functional layer in which a layer made of a material with a low glass transition temperature was sandwiched between layers made of materials with high glass transition temperatures. As a result, it was found that the degradation in luminance was restrained even when the device was kept in a hot environment for a long period of time.

An organic EL device, as shown in Fig. 1, comprises a transparent positive electrode 2, an organic functional layer 3, and a metal negative electrode 4 which are successively laminated on a transparent substrate 1 made of, for example, glass, plastic or the like. Light is emitted from the side of the transparent substrate 1. To take out the emission of the light, at least one of the positive and negative electrodes has to be transparent or translucent. The organic functional layer 3 made of an organic compound comprises a plurality of layers. Each of the plurality of layers has a function as, for example, a hole injection layer 30, a hole transport layer 31, a light emitting layer 32, and an electron transport layer 33 which are laminated from the side of the transparent electrode 2 as shown in Fig. 1. An electron injection layer 34 may be provided between the electron transport layer 33 and the metal electrode 4 to increase efficiency in electron injection. Each of the light emitting layer and the electric charge transport layer such as the hole transport layer and the electron transport layer may be composed of multiple layers.

The transparent electrode 2 has a function as the positive electrode for supplying holes to the organic functional layer.

Examples of the material for the positive electrode include metals, alloys, metal oxides, electric conductive compounds, and mixtures thereof. It is preferable to use a material the work function of which is equal to or higher than 4 eV. The positive electrode may be made of, for example, indium tin oxide (ITO), antimony-doped tin oxide (ATO), fluorine-doped tin oxide (FTO), semiconductive metal oxides (tin oxide, zinc oxide, indium oxide, indium zinc oxide (IZO), and the like), metals (gold, silver, chromium, nickel, and the like), mixtures or laminates of the metal and a conductive metal oxide, inorganic conductive materials (copper iodide, copper sulfide, and the like), organic conductive materials (polyaniline, polythiophene, polypyrrole, and the like), laminates of the organic conductive material and ITO, or the like. The thickness of the positive electrode is, for example, approximately 1000 to 300 nm in the case of ITO, and approximately 800 to 150 nm in the case of gold. The thickness of the positive electrode, however, may be appropriately selected in accordance with the kind of material and its transmittance.

The metal electrode 4 has a function as the negative electrode for injecting electrons into the organic functional layer. Examples of the material for the negative electrode include metals, alloys, metal oxides, electric conductive compounds, and mixtures thereof. It is preferable that the metal electrode is made of a material with low resistance such as aluminum. Alternatively, alloys such as a lithium/aluminum alloy and a magnesium/aluminum alloy, or a mixture thereof may be used instead of using only aluminum. To increase the efficiency in electron injection into the organic functional layer, the electron injection layer 34 with a thickness of approximately a few angstroms which is made of LiF (lithium fluoride), Li2O (lithium oxide), CsF (cesium fluoride) or the like may be inserted. It is preferable that the metal electrode and the electron injection layer, which are adjacent to the organic functional layer, are made of materials the work function of which is equal to or lower than 4.5 eV. For example, an alkali metal (Li, Na, K, Cs, and the like) or an alkaline-earth metal (Mg, Ca, and the like) may be added to the materials. The materials may be used alone, but it is preferable to use two or more types of materials together in order to obtain both of stability and the function of injecting the electrons.

An organic EL device comprises the organic functional layer which is formed between a pair of the positive and negative electrodes opposed to each other. The organic functional layer comprises three or more thin films including the light emitting layer which is made of an organic compound. The organic functional layer includes a pair of first and second layers (the hole transport layer 31 and the electron transport layer 33, or the hole injection layer 30 and the light emitting layer 32), and a third layer (the light emitting layer 32 or the hole transport layer 31) held between the first and second layers. Each of the first and second layers is made of an organic compound the glass transition temperature of which is equal to or higher than a first temperature of, for example, 107 °C. The third layer is made of an organic compound the glass transition temperature of which is lower than the first temperature. In the organic EL device, the difference between the glass transition temperature of the third layer and the glass transition temperature of the first or second layer is equal to or more than 12 °C. The materials for the first, second, and third layers are selected from materials having the foregoing relation of the glass transition temperatures. In the organic EL device, the organic compound included in the third layer shows photoluminescence, and it is preferable that the peak thereof is equal to or less than 500 nm.

When the difference in the glass transition temperature between the third layer and the first or second layer is equal to or more than 12 °C, the degradation in luminance does not occur even if the organic EL device is kept in the environment at a high temperature for a long period of time. The glass transition temperature indicates the thermal stability of an organic compound. The higher the glass transition temperature, the more thermally stable an amorphous thin film becomes. If the first temperature is 107 °C, it is possible to obtain stable emission of light with long hours of energization due to thermal stability. The present values are measured by a differential scanning calorimeter.

The sandwiched third layer may be the hole injection layer, the hole transport layer, the electron transport layer or the electron injection layer instead of the light emitting layer, as long as the glass transition temperature of the third layer is lower than those of the sandwiching first and second layers.

Hole transport materials, which make the hole injection layer and the hole transport layer in the organic EL device, are selected from compounds which have the function of transporting holes and injecting holes in addition to the foregoing conditions, and can prevent electrons from moving into the hole transport layer if possible. Examples of the hole transport materials include phthalocyanine derivatives, naphthalocyanine derivatives, porphyrin derivatives, aromatic diamine derivatives such as 4,4'-bis[N-(naphthyl)-N-phenylamino]biphenyl (α-NPD), and amine compounds.

Examples of a host material of the light emitting layer in the organic EL device include condensed polycyclic derivatives such as anthracene, naphthalene, pyrene, tetracene, coronene, perylene, phthaloperylene, and naphthaloperylene; and quinolinol metal complexes such as tris(8-hydroxyquinolinato)aluminum, tris(4-methyl-8-quinolinato)aluminum, tris(5-phenyl-8-quinolinato)aluminum, and bis(4-methyl-8-quinolinato)aluminum. BAlq (Tg = 99 °C) represented by the chemical formula (1) described below, or BEM-B (Tg = 130 °C) represented by the chemical formula (3) described below can be used as the host material of the organic light emitting layer. Particularly, according to the invention, Host (Tg=113 °C) represented by the chemical formula (2) described below is used as the host material of the organic light emitting layer

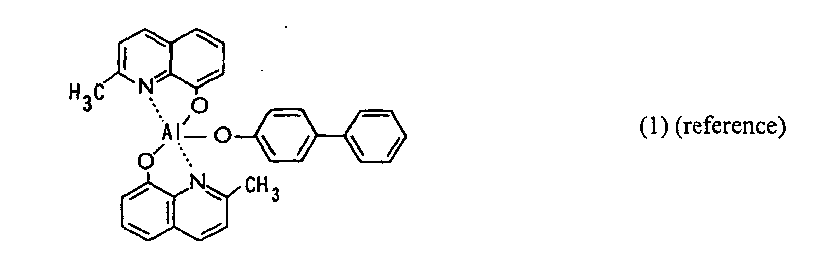

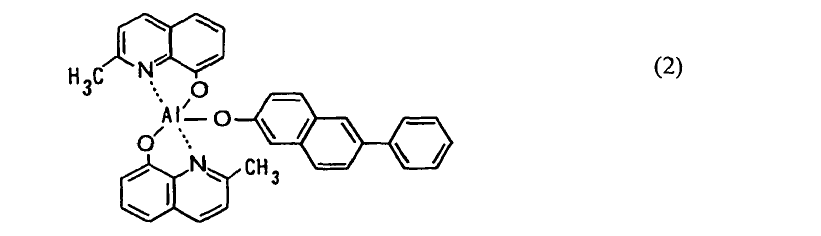

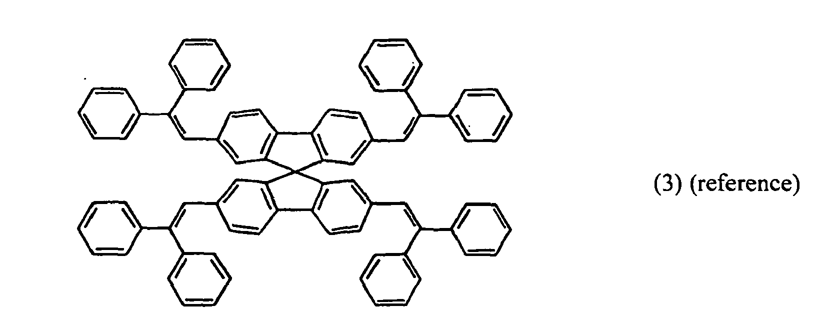

Examples of a doping material for the light emitting layer include fluorescent materials such as a coumarin compound, a quinacridon compound, and a stilamine compound, and phosphorescent materials such as an iridium complex the ligand of which is phenylpyridine, acetylacetone, or the like. FIrpic represented by the chemical formula (5) described below or Ir (ppy) 3 represented by the chemical formula (6) described below can be used as the doping material for the organic light emitting layer. According to the invention specifically BtpIr represented by the chemical formula (4) described below is used as the doping material for the organic light emitting layer.

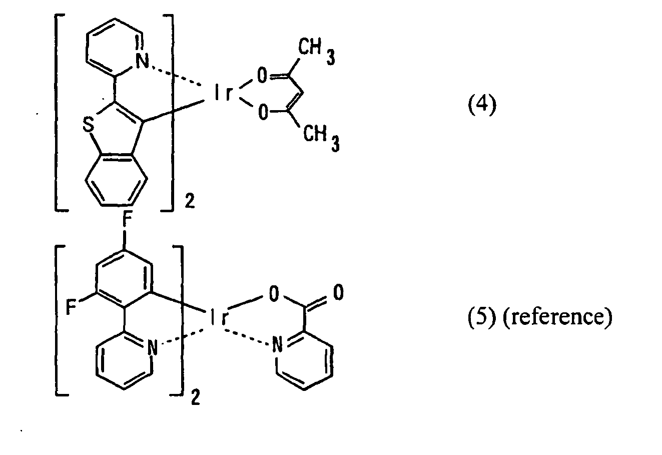

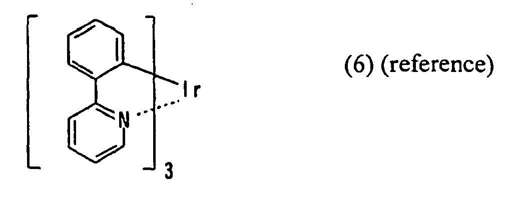

An electron transport material, which makes the electron transport layer in the organic EL device, is selected from compounds which have the function of transporting electrons and injecting electrons in addition to the foregoing conditions, and can prevent holes from moving into the electron transport layer if possible. Examples of the electron transport materials include triazole derivatives, oxazole derivatives, oxadiazole derivatives, fluorenone derivatives, anthraquinodi-methane derivatives, anthorone derivatives, diphenylquinone derivatives, thiopyran dioxide derivatives, carbodiimide derivatives, fluorenylidene methane derivatives, distyrylpyrazine derivatives, heterocyclic tetracarboxylic acid anhydrides such as naphthalene perylene, metal complexes such as a phthalocyanine derivative and a quinolinol derivative, metal complexes the ligand of which is metallophthalocyanine,benzooxazole,benzothiazole,or the like, aniline copolymer, conductive polymers such as thiophene oligomer and polythiophene, polythiophene derivatives, polyphenylene derivatives, polyphenylenevinylene derivatives, and polyfluorene derivatives.

### [Reference Example 1]

Concretely, a plurality of samples of an organic EL device were fabricated to evaluate light emission characteristics.

In each sample, the following materials were successively deposited onto an ITO positive electrode (thickness: 110 nm) on a substrate, to fabricate the organic EL device having the following configuration.

An organic functional layer was laminated as shown in Fig. 1, by using copper phthalocyanine (CuPc) (thickness: 25 nm) in a hole injection layer, HTM-A (thickness: 105 nm) in a hole transport layer, BEM-A (thickness: 30 nm) in a light emitting layer, Alq3 (thickness: 20 nm) in an electron transport layer. CuPc being a hole injection material is thermally stable, and both of the glass transition temperature and the melting point thereof are not observed up to 300 °C in thermal analysis. HTM-A is a hole transport material the glass transition temperature of which is 120 °C. BEM-A is a blue light emitting material having a glass transition temperature of 106 °C. Alq3 functioning as an electron transport material has a glass transition temperature of 167 °C.

Then, in each sample, LiF was evaporated on the electron transport layer as an electron injection layer to have a thickness of 1 nm. Furthermore, aluminum (Al) was laminated thereon as a negative electrode with a thickness of 100 nm, to fabricate the samples of organic light emitting devices of the example.

### [Reference Example 2]

Organic EL devices as example 2 were fabricated in a similar manner to the example 1, except that HTM-B (thickness: 105 nm) having a glass transition temperature of 135 °C was used instead of HTM-A in the hole transport layer in the example 1.

### [Reference Comparative Example 1]

Organic EL devices as comparative example 1 were fabricated in a similar manner to the example 1, except that α-NPD (thickness: 105 nm) having a glass transition temperature of 96 °C was used instead of HTM-A in the hole transport layer in the example 1.

The organic EL devices of the example 1, the example 2, and the comparative example 1 were kept in a thermostatic chamber at 100 °C for a predetermined time (hours). The table 1 shows variations in chromaticity and luminous efficiency (cd/A) of the devices, when the devices were driven with 5.5 mA/cm² after that.

### Reference Table 1

| | Hole transport material | Elapsed time (hr) at 100°C | Chromaticity | | Lumi. effi. (cd/A) |
|---|---|---|---|---|---|
| | | | CIEx | CIEy | |
| Example 1 | HTM-A Tg = 120°C | 0 | 0.144 | 0.111 | 4.1 |
| | | 100 | 0.143 | 0.111 | 4.2 |
| | | 250 | 0.143 | 0.110 | 4.3 |
| | | 500 | 0.143 | 0.109 | 4.3 |
| Example 2 | HTM-8 Tg = 135°C | 0 | 0.144 | 0.111 | 3.8 |
| | | 100 | 0.143 | 0.108 | 3.8 |
| | | 250 | 0.144 | 0.107 | 3.8 |
| | | 500 | 0.143 | 0.108 | 4.0 |
| Compar. example 1 | α-NPD Tg=96°C | 0 | 0.146 | 0.115 | 3.6 |
| | | 100 | 0.287 | 0.469 | 0.8 |
| | | 250 | 0.299 | 0.483 | 0.8 |
| | | 500 | 0.300 | 0.482 | 0.6 |

As apparent from the table 1, the chromaticity and the luminous efficiency did not vary in the example 1 and the example 2, even after the devices were kept in the thermostatic chamber at 100 °C for 500 hours. In the comparative example 1, as compared with them, luminous color changed from blue to green at a point in time when 100 hours had elapsed, and the luminous efficiency became a quarter of an initial value or less.

### [Reference Example 3]

Organic EL devices as example 3 were fabricated in a similar manner to the example 1, except that the thickness of HTM-A in the hole transport layer in the example 1 was thinned to 55 nm, and BAlq being a host material to which BtpIr being a dopant material was added was used instead of BEM-A in the light emitting layer (thickness: 47.5 nm), and the thickness of Alq3 in the electron transport layer was thickened to 30 nm. BAlq in the light emitting layer has a glass transition temperature of 99 °C. BtpIr is a phosphorescent dopant.

### [Reference Example 4]

Organic EL devices as example 4 were fabricated in a similar manner to the example 3, except that HTM-C (thickness: 55 nm) having a glass transition temperature of 143 °C was used in the hole transport layer, instead of HTM-A in the hole transport layer in the structure of the device according to the example 3.

### [Reference Comparative Example 2]

Organic EL devices as comparative example 2 were fabricated in a similar manner to the example 3, except that a-NPD having a glass transition temperature of 96 °C was used instead of HTM-A as the hole transport material in the structure of the device according to the example 3.

The organic EL devices of the example 3, the example 4, and the comparative example 2 were kept in the thermostatic chamber at 100 °C for a predetermined time (hours). The table 2 shows variations in chromaticity and luminous efficiency (cd/A) of the devices, when the devices were driven with 5.5 mA/cm² after that.

### Reference Table 2

| | Hole transport material | Elapsed time (hr) at 100°C | Chromaticity | | Lumi. effi. (cd/A) |
|---|---|---|---|---|---|
| | | | CIEx | CIEy | |
| Example 3 | HTM-A Tg = 120°C | 0 | 0.677 | 0.321 | 6.5 |
| | | 100 | 0.678 | 0.320 | 6.3 |
| | | 250 | 0.677 | 0.321 | 6.4 |
| | | 500 | 0.678 | 0.321 | 6.2 |
| Example 4 | HTM-C Tg = 143°C | 0 | 0.676 | 0.322 | 5.8 |
| | | 100 | 0.676 | 0.321 | 5.8 |
| | | 250 | 0.676 | 0.322 | 5.7 |
| | | 500 | 0.676 | 0.323 | 5.6 |
| Compar. example 2 | α-NPD Tg = 96°C | 0 | 0.678 | 0.321 | 6.1 |
| | | 100 | 0.645 | 0.344 | 2.3 |
| | | 250 | 0.567 | 0.394 | 1.1 |
| | | 500 | 0.531 | 0.415 | 1.2 |

As apparent from the table 2, the chromaticity and the luminous efficiency did not vary in the example 3 and the example 4, even after the devices were kept in the thermostatic chamber at 100 °C for 500 hours. As compared with them, in the comparative example 2, luminous color changed from red to orange at a point in time when 100 hours had elapsed, and the luminous efficiency became one-fifth of an initial value or less.

### [Reference Example 5]

Organic EL devices as example 5 were fabricated in a similar manner to the example 1, except that α-NPD (thickness: 105 nm) having a glass transition temperature of 96 °C was used instead of HTM-A in the hole transport layer in the example 1, and BEM-B (thickness: 30 nm) being a blue light emitting material with a glass transition temperature of 130 °C was used instead of BEM-A in the light emitting layer. A peak of photoluminescence of a-NPD is 437 nm.

### [Reference Comparative Example 3]

Organic EL devices as comparative example 3 were fabricated in a similar manner to the example 5, except that BEM-A having a glass transition temperature of 106 °C was used instead of BEM-B being the blue light emitting material in the light emitting layer in the structure of the device according to the example 5. (This structure is the same as that of the comparative example 1).

The organic EL devices of the example 5 and the comparative example 3 were kept in the thermostatic chamber at 100 °C for a predetermined time (hours). The table 3 shows variations in chromaticity and luminous efficiency (cd/A) of the devices, when the devices were driven with 5.5 mA/cm² after that.

### Reference Table 3

| | Hole transport material | Elapsed time (hr) at 100°C | Chromaticity | | Lumi. effi. (cd/A) |
|---|---|---|---|---|---|
| | | | CIEx | CIEy | |
| Example 5 | BEM-B Tg = 130°C | 0 | 0.146 | 0.229 | 2.4 |
| | | 20 | 0.148 | 0.231 | 2.4 |
| | | 100 | 0.159 | 0.247 | 2.2 |
| Compar. example 3 | BEM-A Tg = 106°C | 0 | 0.146 | 0.115 | 3.6 |
| | | 20 | 0.146 | 0.113 | 3.7 |
| | | 100 | 0.287 | 0.469 | 0.8 |

As apparent from the table 3, the chromaticity and the luminous efficiency did not significantly vary in the example 5, even after the devices were kept in the thermostatic chamber at 100 °C for 500 hours. In the comparative example 3, as compared with the example 5, luminous color changed from blue to green at a point in time when 100 hours had elapsed, and the luminous efficiency became a quarter of an initial value or less.

### [Example 6]

According to the invention organic EL devices as example 6 were fabricated in a similar manner to the example 1, except that α-NPD (thickness: 55 nm) having a glass transition temperature of 96 °C was used instead of HTM-A in the hole transport layer in the example 1, and the foregoing Host, in which BtpIr being the dopant material was added to the host, having a glass transition temperature of 113 °C was used in the light emitting layer (thickness: 47.5 nm) instead of BEM-A, and the thickness of Alq3 in the electron transport layer was thickened to 30 nm.

### [Reference Comparative Example 4]

Organic EL devices as comparative example 4 were fabricated in a similar manner to the example 6, except that BAlq having a glass transition temperature of 99 °C was used instead of Host in the light emitting layer in the structure of the devices according to the example 6. (This structure is the same as that of the comparative example 2).
The organic EL devices of the example 6 and the comparative example 4 were kept in the thermostatic chamber at 100 °C for a predetermined time (hours). The table 4 shows variations in chromaticity and luminous efficiency (cd/A) of the devices, when the devices were driven with 5.5 mA/cm² after that.

**Table 4**

| | Hole transport material | Elapsed time (hr) at 100°C | Chromaticity | | Lumi. effi. (cd/A) |
|---|---|---|---|---|---|
| | | | CIEx | CIEy | |
| Example 6 | Host Tg = 113°C | 0 | 0.676 | 0.321 | 5.9 |
| | | 150 | 0.673 | 0.324 | 5.3 |
| | | 300 | 0.672 | 0.325 | 4.3 |
| Compar. example | BAlq 4 Tg = 99°C | 0 | 0.678 | 0.321 | 6.1 |
| | | 150 | 0.576 | 0.386 | 1.2 |
| | | 300 | 0.528 | 0.416 | 1.2 |

As apparent from the table 4, the chromaticity and the luminous efficiency did not significantly vary in the example 6, even after the devices were kept in the thermostatic chamber at 100 °C for 300 hours. As compared with the example 6, in the comparative example 4, luminous color changed from red to orange at a point in time when 150 hours had elapsed, and the luminous efficiency became one-fifth of an initial value.

The table 5 shows the states of the organic functional layers of the Reference examples 1 to 5, example 6 and the comparative examples 1 to 4_{.}

**Table 5**

| | Materials for organic functional layers | | | |
|---|---|---|---|---|
| Reference Ex.1 | CuPc(Tg=>300°C) | HTM-A(Tg=120"C) | BEM-A(Tg=106°C) | Alq3(Tg=167°C) |
| Reference Ex.2 | CuPc(Tg=>300°C) | HTM-B(Tg=135°C) | BEM-A(Tg=106°C) | Alq3(Tg=167°C) |
| Reference C.ex.1. 3 | CuPc(Tg=>300°C) | α -NPD(Tg=96°C) | BEM-A(Tg=106°C) | Alq3(Tg=167°C) |
| Reference Ex.3 | CuPc(Tg=>300°C) | HTM-A(Tg=120°C) | BAlq(Tg=99°C)+BtpIr | Alq3(Tg=167°C) |
| Reference Ex.4 | CuPc(Tg=>300°C) | HTM-C(Tg=143°C; | BAlq(Tg=99°C)+BtpIr | Alq3(Tg=167°C) |
| Reference C.ex.2, 4 | CuPc(Tg=>300°C) | α-NPD(Tg=96°C) | BAlq(Tg=99°C)+BtpIr | Alq3(Tg=167°C) |
| Reference Ex.5 | CuPc(Tg=>300°C) | α-NPD(Tg=96°C) | BEM-B(Tg=130 °C) | Alq3(Tg=167°C) |
| Reference Ex.6 | CuPc(Tg=>300°C) | α-NPD(Tg=96°C) | Host(Tg=113°C)+BtpIr | Alq3(Tg=167°C) |

Since the organic EL device is structured in the manner of the present embodiments, problems such as degradation in luminance and variation in chromaticity do not occur even if the device is kept in an environment at a high temperature. Also, there is an effect that the selection of materials becomes easy. In particular, applying the present invention improves the reliability of a product which is on the premise of being mounted on a vehicle.

## Claims

1. An organic electroluminescent device comprising: a pair of positive and negative electrodes (2, 4) opposed to each other; an organic functional layer (3) formed between the positive and negative electrodes (2, 4),
wherein the functional layer (3) comprises
- a hole injection layer (30) made of copper phtalocyanine (CuPc);
- a hole transport layer (30) made of a-NPD;
- a light emitting layer (32) made of a host material represented by the chemical formula 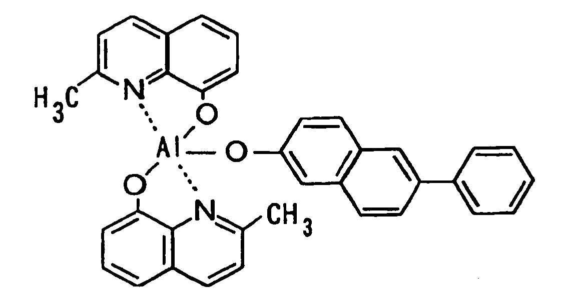
- an electron transport layer (33) made of Alq3.

2. Organic electroluminescent device according to claim 1, **characterized in that** an electron injection layer (34) is formed between the negative electrode (4) and the electron transport layer (33).

## Patentansprüche

1. Organische Elektrolumineszenzvorrichtung mit: einem aus einer positiven und einer entgegengesetzten negativen Elektrode (2, 4) bestehenden Elektrodenpaar; einer organischen Funktionsschicht (3), die zwischen der positiven und der negativen Elektrode (2, 4) gebildet ist,
wobei die Funktionsschicht (3)
- eine aus Kupferphthalocyanin (CuPc) gebildete Lochinjektionsschicht (30);
- eine aus a-NPD gebildete Lochleitungsschicht (30);
- eine lichtemittierende Schicht (32), hergestellt aus einem Material mit der chemischen Formel 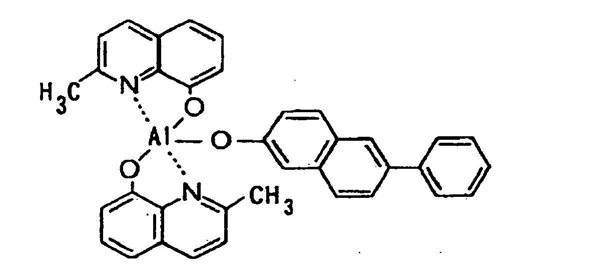
- eine aus Alq3 gebildete Elektronentransportschicht (33) aufweist.

2. Organische Elektrolumineszenzvorrichtung nach Anspruch 1, **dadurch gekennzeichnet, dass** eine Elektroneninjektionsschicht (34) zwischen der negativen Elektrode (4) und der Elektronentransportschicht (33) gebildet ist.

## Revendications

1. Dispositif électroluminescent organique comprenant : une paire d'électrodes positive et négative (2, 4) faisant face l'une à l'autre ; une couche fonctionnelle organique (3) formée entre les électrodes positive et négative (2, 4)
dans lequel la couche fonctionnelle (3) comprend
- une couche d'injection d'orifices (30) composée de phtalocyanine de cuivre (CuPc) ;
- une couche de transport d'orifices (30) composée de a-NPD ;
- une couche d'émission de lumière (32) composée d'un matériau hôte représenté par la formule chimique 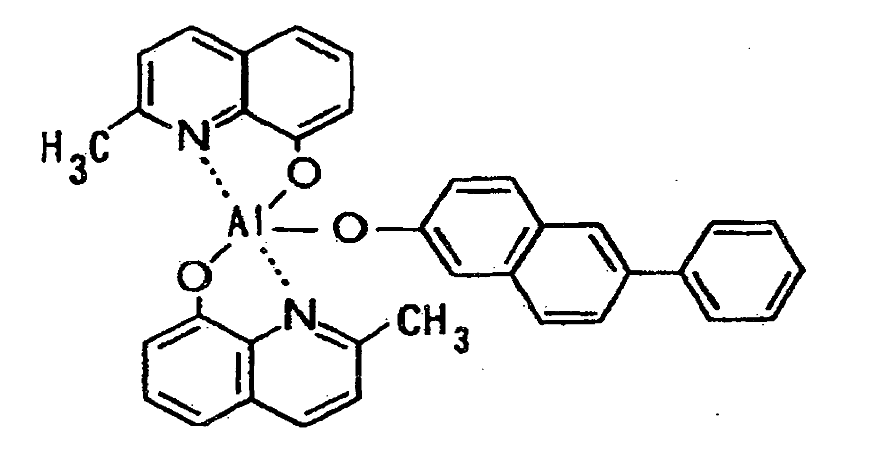
- une couche de transport d'électrons (33) composée de Alq3.

2. Dispositif électroluminescent organique selon la revendication 1, **caractérisé en ce qu'**une couche d'injection d'électrons (34) est formée entre l'électrode négative (4) et la couche de transport d'électrons (33)
